# EUROPEAN PATENT APPLICATION

(11) **EP 2 400 571 A1**
(43) Date of publication of application: **28.12.2011**
(21) Application number: 10743493.8
(22) Date of filing: 25.01.2010
(51) Int. Cl.: H01L 33/64, F21S 2/00, F21Y 101/02

(54) **LIGHT-EMITTING DIODE, LIGHT-EMITTING DIODE LAMP, AND METHOD FOR PRODUCING LIGHT-EMITTING DIODE**

(30) Priority: 18.02.2009 JP 2009035710
(71) Applicant: Showa Denko K.K., Tokyo 105-8518 (JP)
(72) Inventor: TAKEUCHI, Ryouichi, Chichibu-shi Saitama 369-1893 (JP); MATSUMURA, Atsushi, Chichibu-shi Saitama 369-1893 (JP); MASUYA, Kyousuke, Chichibu-shi Saitama 369-1893 (JP)
(74) Representative: Strehl Schübel-Hopf & Partner
(86) International application number: PCT/JP2010/000399
(87) International publication number: WO 2010/095361

(57) **Abstract**

The object of the invention is to provide a light-emitting diode that is excellent in terms of thermal radiation properties and is capable of suppressing cracks in the substrate during joining and emitting light with high luminance by applying a high voltage, a light-emitting diode lamp, and a method of manufacturing a light-emitting diode. The above object is achieved by using a light-emitting diode (1) having a heatsink substrate (5) joined to a light-emitting portion (3) including a light-emitting layer (2), in which the heatsink substrate (5) is formed by alternately laminating a first metal layer (21) and a second metal layer (22); the first metal layer (21) has a thermal conductivity of 130 W/m·K or higher and is made of a material having a thermal expansion coefficient substantially similar to the thermal expansion coefficient of a material for the light-emitting portion (3); and the second metal layer (22) is made of a material having a thermal conductivity of 230 W/m.K or higher.

## Description

### [Technical Field]

The present invention relates to a light-emitting diode, a light-emitting diode lamp, and a method for manufacturing a light-emitting diode.

### [Background Art]

As a light-emitting diode (English abbreviation: LED) that emits visible light, such as red, orange, yellow, yellow-green, or the like, a compound semiconductor LED is known which includes a light-emitting portion having a light-emitting layer composed of, for example, aluminum phosphide, gallium, and indium (with an compositional formula of (Al_{X}Ga_{1-X})_{Y}In_{1-Y}P; 0≤X≤1, 0<Y≤1) and a substrate on which the light-emitting portion is formed.

As the substrate, gallium arsenide (GaAs) or the like, which is optically opaque with respect to light emitted from the light-emitting layer and is also not very strong mechanically, is generally used.
However, in recent years, in order to produce a visible light-emitting diode with higher luminance, for the purpose of further improvement in the mechanical strength of a light-emitting element, the substrate is removed, and then a supporter layer (substrate) composed of a material that transmits or reflects emitted light and is excellent in terms of mechanical strength is joined thereto.
For example, PLTs 1 to 7 discloses technologies in which the supporter layer (substrate) is further joined to the light-emitting layer (joined LED-forming technologies). Furthermore, PLT 8 discloses a technology related to the above joining technology which is a light-emitting element having an ohmic metal implanted in an organic adhesion layer between a metal layer and a reflection layer.

As a result of the development of the joined LED-forming technologies, the degree of freedom of a substrate joined to a light-emitting portion has increased, and the use of a heatsink substrate composed of, for example, a metal with high thermal radiation properties, a ceramic, or the like has become possible. The use of a heatsink substrate as the substrate secures thermal radiation properties from the light-emitting portion so as to make it possible to suppress degradation of a light-emitting layer and to increase the service life.
Particularly, with regard to a high output light-emitting diode that needs to tolerate high electric current so as to shine with high luminance, the securement of thermal radiation properties becomes a more important issue due to the larger heating value than that in the related art. Therefore, joining a heatsink substrate to a light-emitting portion is more useful to prolong the service life of a light-emitting diode.

However, since the heatsink substrate composed of a metal with high thermal radiation properties, a ceramic, or the like has a thermal expansion coefficient that is significantly different from the thermal expansion coefficient of the light-emitting portion, there have been cases in which cracks occurred in the light-emitting portion and/or the heatsink substrate when the heatsink substrate was joined to the light-emitting portion or in the subsequent thermal treatments or the like. As a result, there have been cases in which the yield ratio of the manufacture of a light-emitting diode has been significantly lowered.

As a heatsink substrate, if it is possible to use a material having a thermal expansion coefficient within 1 ppm/K of the thermal expansion coefficient of the light-emitting portion and a thermal conductivity of 200 W/K or higher, it is possible to suppress an occurrence of cracks or the like in the thermal treatments or the like and to sufficiently secure thermal radiation properties. However, no materials have been reported that can satisfy both characteristics of the thermal expansion coefficient and the thermal conductivity.

### [Citation List]

### [Patent Literature]

[Patent Literature 1]
   Japanese Patent No. 3230638
[Patent Literature 2]
   Japanese Unexamined Patent Application, First Publication No. 6-302857
[Patent Literature 3]
   Japanese Unexamined Patent Application, First Publication No. 2002-246640
[Patent Literature 4]
   Japanese Patent No. 2588849
[Patent Literature 5]
   Japanese Unexamined Patent Application, First Publication No. 2001-57441
[Patent Literature 6]
   Japanese Unexamined Patent Application, First Publication No. 2007-81010
[Patent Literature 7]
   Japanese Unexamined Patent Application, First Publication No. 2006-32952
[Patent Literature 8]
   Japanese Unexamined Patent Application, First Publication No. 2005-236303

### [Summary of Invention]

### [Technical Problem]

The invention has been made in consideration of the above circumstances, and the object of the invention is to provide a light-emitting diode that is excellent in terms of thermal radiation properties and is capable of suppressing cracks in the substrate during joining and emitting light with high luminance by applying a high voltage, a light-emitting diode lamp, and a method of manufacturing a light-emitting diode.

### [Solution to Problem]

In order to achieve the above object, the invention adopts the following configurations. That is,
(1) A light-emitting diode of the invention is a light-emitting diode having a heatsink substrate joined to a light-emitting portion including a light-emitting layer, in which the heatsink substrate is formed by alternately laminating a first metal layer and a second metal layer; the first metal layer has a thermal conductivity of 130 W/m·K or higher and is made of a material having a thermal expansion coefficient substantially similar to the thermal expansion coefficient of a material for the light-emitting portion; and the second metal layer is made of a material having a thermal conductivity of 230 W/m·K or higher.

(2) In the light-emitting diode of the invention, a material for the first metal layer is a material having a thermal expansion coefficient within ±1.5 ppm/K of the thermal expansion coefficient of the light-emitting portion.
(3) In the light-emitting diode of the invention, the first metal layer is made of molybdenum, tungsten, or an alloy thereof.
(4) In the light-emitting diode of the invention, the second metal layer is made of aluminum, copper, silver, gold, an alloy thereof, or the like.

(5) In the light-emitting diode of the invention, the first metal layer is made of molybdenum; the second metal layer is made of copper; and the total number of the first metal layers and the second metal layers is from 3 layers to 9 layers.
(6) In the light-emitting diode of the invention, the first metal layer is made of molybdenum, and the total thickness of the first metal layers is from 15% to 45% of the thickness of the heatsink substrate.
(7) The light-emitting diode of the invention includes a reflection structure between the light-emitting portion and the heatsink substrate.

(8) In the light-emitting diode of the invention, the light-emitting layer includes an AlGaInP layer or an AlGaAs layer.
(9) In the light-emitting diode of the invention, the light-emitting layer has a substantially rectangular shape with a diagonal length of 1 mm or larger when viewed from the top, and light is emitted by applying 1 W or more of electric power to the light-emitting layer.
(10) In the light-emitting diode of the invention, the surface of the heatsink substrate on the opposite side of the light-emitting portion is made of copper, and a metal laminate film is formed so as to cover the surface on the opposite side of the light-emitting portion and a side surface of the heatsink substrate.

(11) A light-emitting diode lamp of the invention is a light-emitting diode lamp having the above-described light-emitting diode and a package substrate mounting the light-emitting diode, in which the thermal resistance of the package substrate is 10 °C/W or lower.
(12) In the light-emitting diode lamp of the invention, light is emitted by applying 1 W or more of electric power to a light-emitting layer of the light-emitting diode.

(13) A method for manufacturing a light-emitting diode of the invention includes a process in which a light-emitting portion including a light-emitting layer is formed on a semiconductor substrate via a buffer layer, and then a second electrode is formed on the surface of the light-emitting portion on the opposite side of the semiconductor substrate;
a process in which a reflection structure is formed on the surface of the light-emitting portion on the opposite side of the semiconductor substrate via the second electrode; a process in which a heatsink substrate is joined to the light-emitting portion via the reflection structure; a process in which the semiconductor substrate and the buffer layer are removed; and a process in which a first electrode is formed on the surface of the light-emitting portion on the opposite side of the heatsink substrate.

(14) In the method for manufacturing a light-emitting diode of the invention, the heatsink substrate is formed by pressing first metal layers, which has a thermal conductivity of 130 W/m·K or higher and a thermal expansion coefficient substantially similar to the thermal expansion coefficient of the light-emitting portion, and a second metal layer having a thermal conductivity of 230 W/m·K or higher at a high temperature.

### [Effects of Invention]

According to the above configuration, it is possible to provide a light-emitting diode that is excellent in terms of thermal radiation properties and is capable of suppressing cracks in a substrate during joining and of emitting light with high luminance by applying a high voltage, a light-emitting diode lamp, and a method for manufacturing a light-emitting diode.

The light-emitting diode of the invention is a light-emitting diode having a heatsink substrate joined to a light-emitting portion including a light-emitting layer, in which the heatsink substrate is formed by alternately laminating a first metal layer and a second metal layer; the first metal layer has a thermal conductivity of 130 W/m·K or higher and is made of a material having a thermal expansion coefficient substantially similar to the thermal expansion coefficient of a material for the light-emitting portion; and the second metal layer is made of a material having a thermal conductivity of 230 W/m.K or higher. Thus, the light-emitting diode of the invention may have excellent thermal radiation properties and is capable of suppressing cracks in a substrate during joining and of emitting light with high luminance by applying a high voltage to the diode.

The light-emitting diode lamp of the invention is a light-emitting diode lamp having the above-described light-emitting diode and a package substrate mounting the light-emitting diode, and the thermal resistance of the package substrate is 10 °C/W or lower. Thus, the light-emitting diode lamp of the invention may have excellent thermal radiation properties and is capable of emitting light with high luminance by applying a high voltage to the diode lamp.

The method for manufacturing the light-emitting diode of the invention includes a process in which the light-emitting portion including the light-emitting layer is formed on the semiconductor substrate via the buffer layer, and then the second electrode is formed on the surface of the light-emitting portion on the opposite side of the semiconductor substrate; a process in which the reflection structure is formed on the surface of the light-emitting portion on the opposite side of the semiconductor substrate via the second electrode; a process in which the heatsink substrate is joined to the light-emitting portion via the reflection structure; a process in which the semiconductor substrate and the buffer layer are removed; and a process in which the first electrode is formed on the surface of the light-emitting portion on the opposite side of the heatsink substrate. Thus, the method for manufacturing the light-emitting diode of the invention is possible to manufacture a light-emitting diode that is excellent in terms of thermal radiation properties and is capable of suppressing cracks in the substrate during joining and of emitting light with high luminance by applying a high voltage to the diode.

### [Brief Description of Drawings]

Fig. 1 is a cross-sectional view showing an example of a light-emitting diode that is an embodiment of the invention.
Fig. 2 is a cross-sectional view of a process showing an example of a manufacturing process of a heatsink substrate used for a light-emitting diode that is an embodiment of the invention.
Fig. 3 is a cross-sectional view of a process showing an example of a manufacturing process of a light-emitting diode that is an embodiment of the invention.
Fig. 4 is a cross-sectional view of a process showing an example of a manufacturing process of a light-emitting diode that is an embodiment of the invention.
Fig. 5 is a cross-sectional view of a process showing an example of a manufacturing process of a light-emitting diode that is an embodiment of the invention.
Fig. 6 is a cross-sectional view of a process showing an example of a manufacturing process of a light-emitting diode that is an embodiment of the invention.
Fig. 7 is a cross-sectional view of a process showing an example of a manufacturing process of a light-emitting diode that is an embodiment of the invention.
Fig. 8 is a cross-sectional view of a process showing an example of a manufacturing process of a light-emitting diode that is an embodiment of the invention.
Fig. 9 is a cross-sectional view showing an example of a light-emitting diode lamp that is an embodiment of the invention.
Fig. 10 is a cross-sectional view showing another example of a light-emitting diode that is an embodiment of the invention.
Fig. 11 is a cross-sectional view showing another example of a light-emitting diode that is an embodiment of the invention.
Fig. 12 is a cross-sectional view showing another example of a light-emitting diode that is an embodiment of the invention.

### [Description of Embodiments]

Hereinafter, embodiments to carry out the invention will be described.

### (First Embodiment)

### <Light-Emitting Diode>

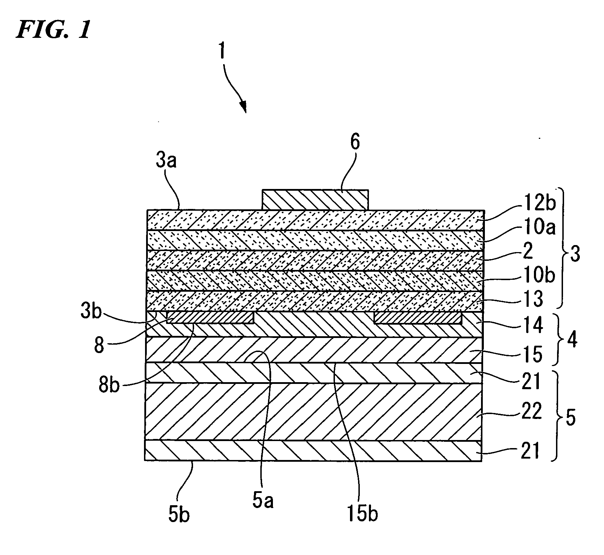

FIG 1 is a view showing an example of a light-emitting diode that is an embodiment of the invention.
As shown in FIG 1, the light-emitting diode (LED) 1, which is an embodiment of the invention, has a light-emitting portion 3 including a light-emitting layer 2, and a heatsink substrate 5 joined to the light-emitting portion 3 via a reflection structure 4. In addition, a first electrode 6 is provided on the surface 3a of the light-emitting portion 3 on the opposite side of the reflection structure 4, and a second electrode 8 is provided on the surface 3b of the light-emitting portion 3 on the reflection structure 4 side.

### <Light-Emitting Portion>

The light-emitting portion 3 is a compound semiconductor-laminate structure including the light-emitting layer 2, which is an epitaxial laminate structure formed by laminating a plurality of epitaxially grown layers.
As the light-emitting portion 3, it is possible to use, for example, an AlGaInP layer, an AlGaAs layer, or the like having high light-emitting efficiency, for which a substrate joining technology is established. The AlGaInP layer is a layer made from a material represented by a general formula of (Al_{X}Ga_{1-X})_{Y}In_{1-Y}P (0≤X≤1, 0<Y≤1). The composition is determined according to the light-emitting wavelength of the light-emitting diode. Similarly, with regard to the AlGaAs layer used when manufacturing a light-emitting diode emitting red and infrared light, the composition of the constituent materials is determined according to the light-emitting wavelength of the light-emitting diode.
The light-emitting portion 3 is a conductive compound semiconductor of either n-type or p-type and has a p-n junction formed therein. Additionally, the polarity on the surface of the light-emitting portion 3 may be any of p-type and n-type polarities.

As shown in FIG 1, the light-emitting portion 3 is composed of, for example, a contact layer 12b, a cladding layer 10a, the light-emitting layer 2, a cladding layer 10b, and a GaP layer 13.
The contact layer 12b is a layer for decreasing the contact resistance of an ohmic electrode, which is composed of, for example, Si-doped n-type (Al_{0.5}Ga_{0.5})_{0.5}In_{0.5}P, and is made to have a carrier concentration of 2×10¹⁸ cm⁻³ and a thickness of 1.5 µm.
In addition, the cladding layer 10a is composed of, for example, Si-doped n-type (Al_{0.7}Ga_{0.3})_{0.5}In_{0.5}P, and is made to have a carrier concentration of 8×10¹⁷ cm⁻³ and a thickness of 1 µm.

The light-emitting layer 2 is composed of, for example, 10 pairs of a laminate structure of undoped (Al_{0.2}Ga_{0.8})_{0.5}In_{0.5}P/(Al_{0.7}Ga_{0.3})_{0.5}In_{0.5}P), and is made to have a thickness of 0.8 µm.
The light-emitting layer 2 has a structure of a double hetero (DH) structure, a single quantum well (SQW) structure, a multi quantum well (MQW) structure, or the like. Herein, the double hetero structure is a structure capable of confining carriers in charge of radiative recombination. In addition, the quantum well structure is a structure having a well layer and two well layers clipping the well layer, and the SQW has one well layer, and the MQW has two or more well layers. As a method for forming the light-emitting portion 3, a MOCVD method or the like can be used.
In order to produce light emission excellent in terms of monochromaticity from the light-emitting layer 2, in particular, it is preferable to use the MQW structure as the light-emitting layer 2.

The cladding layer 10b is composed of, for example, Mg-doped p-type (Al_{0.7}Ga_{0.3})_{0.5}In_{0.5}P, and is made to have a carrier concentration of 2×10¹⁷ cm⁻³ and a thickness of 1 µm.
In addition, the GaP layer 13 is, for example, a Mg-doped p-type GaP layer, and is made to have a carrier concentration of 3×10¹⁸ cm⁻³ and a thickness of 3 µm.

The configuration of the light-emitting portion 3 is not limited to the above-described structures, and may have, for example, an electric current diffusion layer that diffuses electric current for driving elements in a planar manner throughout the light-emitting portion 3, or an electric current inhibition layer, an electric current narrowing layer, or the like for limiting areas where electric current for driving elements flows.

### <First Electrode and Second Electrode>

Each of the first electrode 6 and the second electrode 8 is an ohmic electrode, and the shape and disposition thereof is not particularly limited as long as the electrode can uniformly diffuse electric current to the light-emitting portion 3. For example, it is possible to use a circular or rectangular electrode when viewed from the top, and it is also possible to dispose one electrode or to dispose a plurality of electrodes in a lattice pattern.

As a material for the first electrode 6, it is possible to use, for example, AuGe, AuSi, or the like when an n-type compound semiconductor is used as the contact layer 12b, and to use, for example, AuBe, AuZn, or the like when a p-type compound semiconductor is used as the contact layer 12b.
In addition, it is possible to prevent oxidation and also to improve wire bonding by further laminating Au or the like thereon.

As a material for the second electrode 8, it is possible to use, for example, AuGe, AuSi, or the like when an n-type compound semiconductor is used as the GaP layer 13, and to use, for example, AuBe, AuZn, or the like when a p-type compound semiconductor is used as the GaP layer 13.

### <Reflection Structure>

As shown in FIG 1, the reflection structure 4 is formed on the surface 3b of the light-emitting portion 3 on the reflection structure 4 side so as to cover the second electrode 8. The reflection structure 4 is formed by laminating a metallic film 15 and a transparent conductive film 14.

The metallic film 15 is constituted by a metal, such as copper, silver, gold, aluminum, or the like, and an alloy thereof or the like. The materials have high light reflectivity and thus can achieve a light reflectivity of 90% or higher from the reflection structure 4. By forming the metallic film 15, it is possible to reflect light coming from the light-emitting layer 2 in the front direction f at the metallic film 15 so as to improve the light-extraction efficiency in the front direction f. Thereby, the luminance of a light-emitting diode can be further improved.

The metallic film 15 is made to have a laminate structure composed of an Ag alloy/W/Pt/Au/a connection metal from the transparent conductive film 14 side.
The connection metal formed on the surface 15b of the metallic film 15 on the opposite side of the light-emitting portion 3 is a metal that has a low electrical resistance and is melted at a low temperature. By using the connection metal, it is possible to connect a heatsink substrate without inducing thermal stress on the light-emitting portion 3.
As the connection metal, an Au-based eutectic metal or the like, which is chemically stable and has a low melting point, is used. Examples of the Au-based eutectic metal can include a eutectic composition of an alloy, such as AuSn, AuGe, AuSi, or the like (Au-based eutectic metal).
In addition, it is preferable to add a metal, such as titanium, chromium, tungsten, or the like, to the connection metal. Thereby, the metal, such as titanium, chromium, tungsten, or the like, can act as a barrier metal to prevent the impurities or the like included in the heatsink substrate from diffusing toward the metallic film 15 and causing some reactions.

The transparent conductive film 14 is constituted by an ITO film, an IZO film, or the like. Meanwhile, the reflection structure 4 may be constituted by only the metallic film 15.
In addition, instead of the transparent conductive film 14, or together with the transparent conductive film 14, a so-called cold mirror that uses the difference in the index of refraction between transparent materials may be combined with the metallic film 15, for example, using a multilayer film of a titanium oxide film and a silicon oxide film, white alumina, or AlN.

### <Heatsink Substrate>

A joining surface 5a of the heatsink substrate 5 is joined to the surface 15b of the metallic film 15 which constitutes the reflection structure 4 on the opposite side of the light-emitting portion 3.
The thickness of the heatsink substrate 5 is preferably from 50 µm to 150 µm.
When the thickness of the heatsink substrate 5 is larger than 150 µm, the costs for manufacturing a light-emitting diode are increased, which is not preferable. In addition, when the thickness of the heatsink substrate 5 is smaller than 50 µm, cracks, chips, warpage, or the like occur easily during handling so that there is concern regarding a decrease in the manufacturing yield ratio.

The heatsink substrate 5 is formed by alternately laminating a first metal layer 21 and a second metal layer 22.
The total number of the first metal layers 21 and the second metal layers 22 per heatsink substrate 1 is preferably from 3 layers to 9 layers, and more preferably from 3 layers to 5 layers.
When the total number of the first metal layers 21 and the second metal layers 22 is set to 2 layers, thermal expansion becomes uneven in the thickness direction so that there is concern regarding the occurrence of cracks in the heatsink substrate 5. Conversely, when the total number of the first metal layers 21 and the second metal layers 22 is set to more than 9 layers, it becomes necessary to reduce the thickness of each of the first metal layers 21 and the second metal layers 22. It is difficult to manufacture a single layer substrate composed of the first metal layers 21 or the second metal layers 22 with a reduced thickness so that the thicknesses of the respective layers become uneven, and thus there is concern regarding the occurrence of variation in the characteristics of a light-emitting diode. Furthermore, in the single layer substrate with a reduced thickness, cracks are liable to occur in the substrate. Furthermore, since the manufacture of the single layer substrate is difficult, there is concern regarding an increase in the manufacturing costs of a light-emitting diode.
Meanwhile, the total number of the first metal layers 21 and the second metal layers 22 is more preferably an odd number.

### <First Metal Layer>

The first metal layer 21 preferably has a thermal conductivity of 130 W/m·K or higher. Thereby, the thermal radiation properties of the heatsink substrate 5 are enhanced so that a light-emitting diode 1 is enabled to emit light with high luminance and also to have a longer service life.

In addition, the first metal layer 21 is preferably made of a material having a thermal expansion coefficient substantially similar to the thermal expansion coefficient of the light-emitting portion 3. Particularly, a material for the first metal layer 21 preferably has a thermal expansion coefficient within ±1.5 ppm/K of the thermal expansion coefficient of the light-emitting portion 3. Thereby, it is possible to reduce heat-induced stress to the light-emitting portion 3 during joining so that it is possible to suppress heat-induced cracks in the heatsink substrate 5 when the heatsink substrate 5 and the light-emitting portion 3 are brought into contact and thus to improve the manufacturing yield ratio of a light-emitting diode.

For example, when an AIGaInP layer (with a thermal expansion coefficient of about 5.3 ppm/K) is used as the light-emitting portion 3, it is preferable to use molybdenum (thermal expansion coefficient =5.1 ppm/K), tungsten (thermal expansion coefficient = 4.3 ppm/K), an alloy thereof, or the like as the first metal layer 21.
In addition, the thermal conductivity of molybdenum is 138 W/m·K, and the thermal conductivity of tungsten is 174 W/m.K, and thus both materials have a thermal conductivity equal to or higher than 130 W/m·K.

The total thickness of the first metal layers 21 is preferably from 10% to 45% of the thickness of the heatsink substrate 5, more preferably from 20% to 40%, and further preferably from 25% to 35%. When the total thickness of the first metal layers 21 exceeds 45% of the thickness of the heatsink substrate 5, the effect of the second metal layer 22 having a high thermal conductivity is reduced so that the heatsink function is degraded. Conversely, when the thickness of the first metal layers 21 is less than 10% of the thickness of the heatsink substrate 5, the first metal layers 21 hardly function so that it is not possible to suppress heat-induced cracks in the heatsink substrate 5 when the heatsink substrate 5 and the light-emitting portion 3 are brought into contact. In summary, a large difference in the thermal expansion coefficient between the second metal layer 22 and the light-emitting portion 3 causes heat-induced cracks in the heatsink substrate 5 so that there are cases in which poor joining occurs.
Particularly, when molybdenum is used as the first metal layer 21, the total thickness of molybdenum is preferably from 15% to 45% of the thickness of the heatsink substrate 5, more preferably from 20% to 40%, and further preferably from 25% to 35%.
The thickness of the first metal layer 21 is preferably from 10 µm to 40 um, and more preferably from 20 µm to 30 µm.

### <Second Metal Layer>

The second metal layer 22 is preferably made of a material having a thermal conductivity higher than at least that of the first metal layer 21, and more preferably a material having a thermal conductivity of 230 W/m.K or higher. Thereby, the thermal radiation properties of the heatsink substrate 5 are enhanced so that a light-emitting diode 1 is enabled to emit light with high luminance and also to have a longer service life.

As the second metal layer 22, it is preferable to use, for example, silver (thermal conductivity = 420 W/m·K), copper (thermal conductivity = 398 W/m.K), gold (thermal conductivity = 320 W/m·K), aluminum (thermal conductivity = 236 W/m.K), an alloy thereof, or the like.
The thickness of the second metal layer 22 is preferably from 10 µm to 40 µm, and more preferably from 20 µm to 40 µm.
Meanwhile, the thicknesses of the first metal layer 21 and the second metal layer 22 may be different. Furthermore, when the heatsink substrate 5 is formed with a plurality of the first metal layers 21 and the second metal layers 22, the thickness of each layer may be different.

Meanwhile, a joining auxiliary film that stabilizes electrical contact or a eutectic metal for die bonding may be formed on the joining surface 5a of the heatsink substrate 5. Thereby, a joining process can be easily performed. As the joining auxiliary film, Au, AuSn, or the like can be used.

Meanwhile, the method for joining the heatsink substrate 5 to the light-emitting portion 3 is not limited to the above-described method, and it is possible to apply a well-known technology, for example, diffused junction, an adhesive, a room temperature joining method, or the like.

The light-emitting diode 1, which is an embodiment of the invention, is a light-emitting diode 1 having the heatsink substrate 5 joined to the light-emitting portion 3 including the light-emitting layer 2, in which the heatsink substrate 5 is formed by alternately laminating the first metal layer 21 and the second metal layer 22; the first metal layer 21 has a thermal conductivity of 130 W/m.K or higher and is made of a material having a thermal expansion coefficient substantially similar to the thermal expansion coefficient of a material for the light-emitting portion 3; and the second metal layer 22 is made of a material having a thermal conductivity of 230 W/m·K or higher. Thus, the light-emitting diode 1 of the invention may have excellent thermal radiation properties and is capable of suppressing cracks in a substrate during joining and of emitting light with high luminance by applying a high voltage to the diode 1.

The light-emitting diode 1, which is an embodiment of the invention, has the first metal layers 21 made of a material having a thermal expansion coefficient within ±1.5 ppm/K of the thermal expansion coefficient of the light-emitting portion 3. Thus, the light-emitting diode 1 of the invention may have excellent thermal radiation properties and is capable of suppressing cracks in a substrate during joining and of emitting light with high luminance by applying a high voltage to the diode 1.

The light-emitting diode 1, which is an embodiment of the invention, has the first metal layers 21 made of molybdenum, tungsten, or an alloy thereof. Thus, the light-emitting diode 1 of the invention may have excellent thermal radiation properties and is capable of suppressing cracks in a substrate during joining and of emitting light with high luminance by applying a high voltage to the diode 1.

The light-emitting diode 1, which is an embodiment of the invention, has the second metal layer 22 made of aluminum, copper, silver, gold, an alloy thereof, or the like. Thus, the light-emitting diode 1 of the invention may have excellent thermal radiation properties and is capable of suppressing cracks in a substrate during joining and of emitting light with high luminance by applying a high voltage to the diode 1.

The light-emitting diode 1, which is an embodiment of the invention, has the first metal layers 21 made of molybdenum and the second metal layer 22 made of copper, in which the total number of the first metal layers 21 and the second metal layer 22 is from 3 layers to 9 layers. Thus, the light-emitting diode 1 of the invention may have excellent thermal radiation properties and is capable of suppressing cracks in a substrate during joining and of emitting light with high luminance by applying a high voltage to the diode 1.
The second metal layer 22 may be disposed at the position of the first metal layer 21, and the first metal layer 21 may be disposed at the position of the second metal layer 22. In the case of the above embodiment, the same effect can be obtained even when a copper layer is disposed at the position of the first metal layer 21 and a molybdenum layer is disposed at the position of the second metal layer 22.

### <Method for Manufacturing Light-Emitting Diode>

Next, a method for manufacturing the light-emitting diode, which is an embodiment of the invention, will be described.
A method for manufacturing the light-emitting diode, which is an embodiment of the invention, includes a process for manufacturing the heatsink substrate; a process in which a light-emitting portion including the light-emitting layer is formed on a semiconductor substrate via a buffer layer, and then the second electrode is formed on the surface of the light-emitting portion on the opposite side of the semiconductor substrate; a process in which a reflection structure is formed on the surface of the light-emitting portion on the opposite side of the semiconductor substrate via the second electrode; a process in which a heatsink substrate is joined to the light-emitting portion via the reflection structure; a process in which the semiconductor substrate and the buffer layer are removed; and a process in which a first electrode is formed on the surface of the light-emitting portion on the opposite side of the heatsink substrate.
Firstly, the process for manufacturing the heatsink substrate will be described.

### <Process for Manufacturing Heatsink Substrate>

The heatsink substrate 5 has a thermal conductivity of 130 W/m·K or higher, and is formed by hot-pressing the first metal layers having a thermal expansion coefficient substantially similar to the thermal expansion coefficient of the light-emitting portion and the second metal layer having a thermal conductivity of 230 W/m·K or higher.

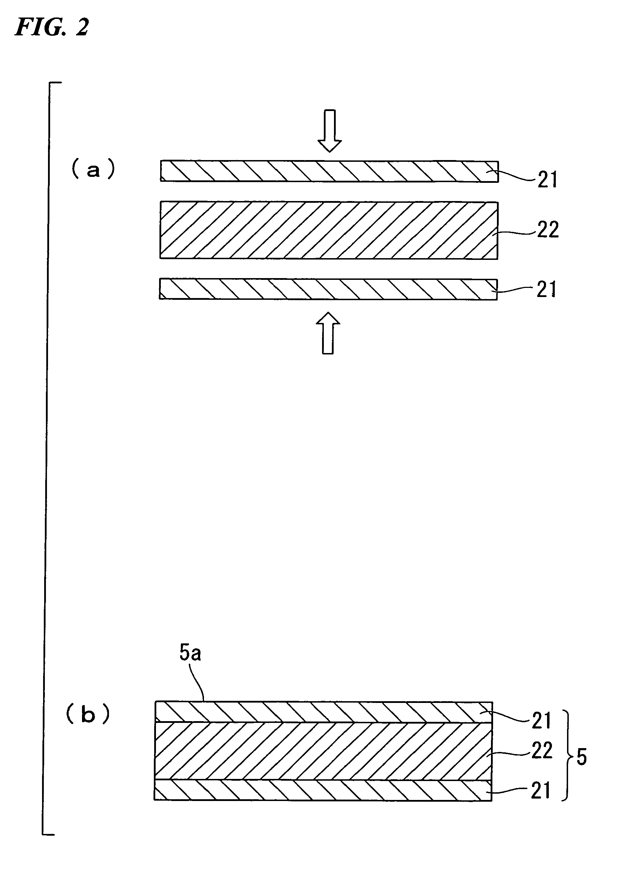

Firstly, two substantially plain plate-shaped first metal plates 21 and a substantially plain plate-shaped second metal plate 22 are prepared. For example, Mo with a thickness of 25 µm is used as the first metal plate 21, and Cu with a thickness of 70 µm is used as the second metal plate 22.
Next, as shown in FIG 2(a), the second metal plate 22 is inserted between two first metal plates 21 so as to be disposed between the first metal plates 21.

Next, the substrate is disposed in a predetermined pressing apparatus, and load is applied to the first metal plate 21 and the second metal plate 22 in the arrow direction under a high temperature. Thereby, as shown in FIG 2(b), the heatsink substrate 5 composed of 3 layers of Mo (25 µm)/Cu (70 µm)/Mo (25 µm) is formed, in which the first metal plate 21 is Mo and the second metal plate 22 is Cu.
The heatsink substrate 5 has, for example, a thermal expansion coefficient of 5.7 ppm/K and a thermal conductivity of 220 W/m.K.

Meanwhile, thereafter, the substrate may be cut according to the size of the joining surface of the light-emitting portion (wafer) 3 and then be mirror-finished for the surfaces.
In addition, a joining auxiliary film may be formed on the joining surface 5a of the heatsink substrate 5 in order to stabilize electrical contact. As the joining auxiliary film, gold, platinum, nickel, or the like can be used. For example, firstly, a 0.1 µm-thick nickel film is formed, and then a 0.5 µm-thick gold film is formed on the nickel film.
Furthermore, instead of the joining auxiliary film, a eutectic metal, such as AuSn or the like, for die bonding may be formed. Thereby, a joining process can be easily performed.

### <Process for Forming Light-Emitting Portion and Second Electrode>

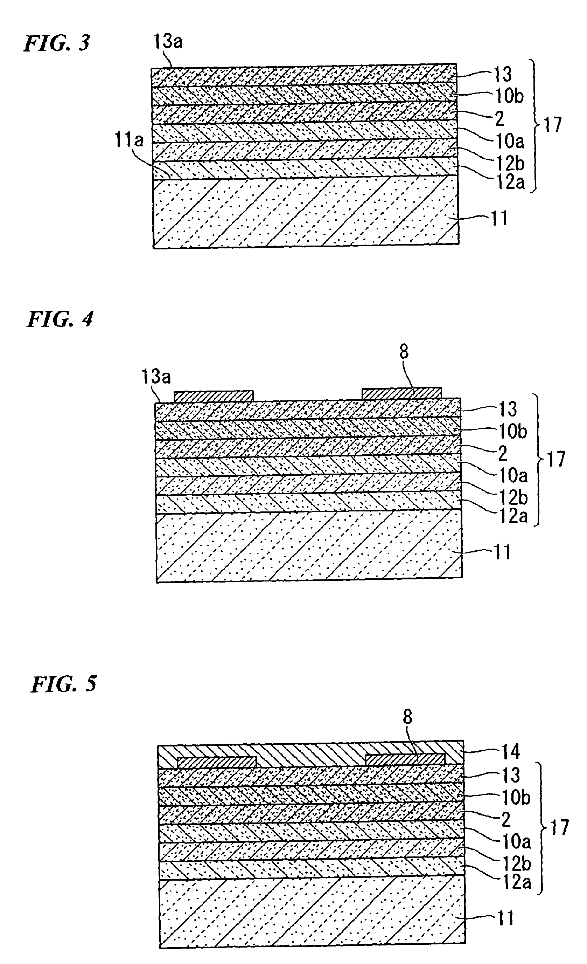

Firstly, as shown in FIG 3, a plurality of epitaxial layers is grown on a surface 11a of the semiconductor substrate 11 so as to form an epitaxial laminate 17.
The semiconductor substrate 11 is a substrate for forming the epitaxial laminate 17, which is, for example, a Si-doped n-type GaAs single crystal substrate having the surface 11a inclined at 15 degrees from the (100) plane. As such, when an AlGaInP layer or an AlGaAs layer is used as the epitaxial laminate 17, it is possible to use a gallium arsenide (GaAs) single crystal substrate as the substrate for forming the epitaxial laminate 17.

As a method for forming the light-emitting portion 3, it is possible to use a metal organic chemical vapor deposition (MOCVD) method, a molecular beam epitaxy (MBE) method, a liquid phase epitaxy (LPE) method, or the like.

In the embodiment, each of the layers is epitaxially grown using a reduced-pressure MOCVD method in which trimethylaluminum ((CH₃)₃Al), trimethylgallium ((CH₃)₃Ga), and trimethylindium ((CH₃)₃In) are used as the raw materials of constituent elements belonging to Group III.
Meanwhile, biscyclopentadienyl magnesium (bis-(C₅H₅)₂Mg) is used as a raw material for doping Mg. In addition, disilane (Si₂H₆) is used as a raw material for doping Si. In addition, phosphine (PH₃) or arsine (AsH₃) is used as the raw material of constituent elements belonging to Group V.
Meanwhile, the p-type GaP layer 13 is grown at, for example, 750 °C, and the other epitaxially grown layers are grown at, for example, 730 °C.

Specifically, firstly, the buffer layer 12a composed of Si-doped n-type GaAs is formed on the surface 11a of the semiconductor substrate 11. As the buffer layer 12a, for example, Si-doped n-type GaAs is used, which has a carrier concentration of 2×10¹⁸ cm⁻³ and a thickness of 0.2 µm.
Next, on the buffer layer 12a, the contact layer 12b composed of Si-doped n-type (Al_{0.5}Ga_{0.5})_{0.5}In_{0.5}P is formed.
Next, on the contact layer 12b, the cladding layer 10a composed of Si-doped n-type (Al_{0.7}Ga_{0.3})_{0.5}In_{0.5}P is formed.
Next, on the cladding layer 10a, the light-emitting layer 2 composed of 10 pairs of laminate structures of undoped (Al_{0.2}Ga_{0.8})_{0.5}In_{0.5}P/(Al_{0.7}Ga_{0.3})_{0.5}In_{0.5}P) is formed.
Next, on the light-emitting layer 2, the cladding layer 10b composed of Mg-doped p-type (Al_{0.7}Ga_{0.3})_{0.5}In_{0.5}P is formed.
Next, on the cladding layer 10b, the Mg-doped p-type GaP layer 13 is formed.

Next, mirror-like polishing is performed on the surface 13a of the p-type GaP layer 13 on the opposite side of the semiconductor substrate 11 at a depth of as much as 1 µm from the surface so that the roughness of the surface becomes, for example, within 0.18 nm.
Next, as shown in FIG 4, the second electrode (ohmic electrode) 8 is formed on the surface 13a of the p-type GaP layer 13 on the opposite side of the semiconductor substrate 11. The second electrode 8 is formed by, for example, laminating 0.2 µm-thick Au on 0.4 µm-thick AuBe. For example, the second electrode 8 is shaped like a circle with a diameter of 20 µm, when viewed from the top, and is formed at an interval of 60 µm.

### <Process for Forming Reflection Structure>

Next, as shown in FIG 5, the transparent conductive film 14 composed of an ITO film is formed so as to cover the surface 13a of the p-type GaP layer 13 on the opposite side of the semiconductor substrate 11 and the second electrode 8. Next, a thermal treatment is performed at 450 °C so as to form ohmic contact between the second electrode 8 and the transparent conductive film 14.

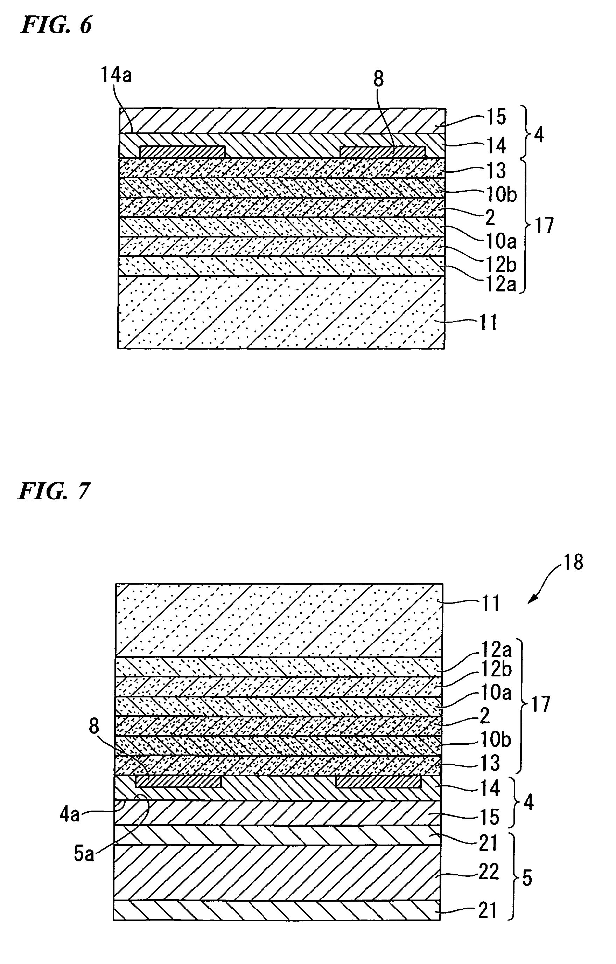

Next, as shown in FIG 6, after a 0.5 µm-thick film composed of a silver (Ag) alloy is formed on the surface 14a of the transparent conductive film 14 on the opposite side of the epitaxial laminate 17 using a vapor deposition method, a 0.1 µm-thick tungsten (W) film, a 0.1 µm-thick platinum (Pt) film, a 0.5 µm-thick gold (Au) film, and 1 µm-thick AuGe eutectic metal (with a melting point of 386 °C) are formed so as to produce the metal film 15.
Thereby, the reflection structure 4 constituted by the metallic film 15 and the transparent conductive film 14 is formed.

### <Process for Joining Heatsink Substrate>

Next, the semiconductor substrate 11, on which the reflection structure 4 and the epitaxial laminate 17 are formed, and the heatsink substrate 5 formed in the process for manufacturing the heatsink substrate are transported in a decompression apparatus and are disposed in a manner such that the joining surface 4a of the reflection structure 4 and the joining surface 5a of the heatsink substrate 5 face each other.
Next, after air in the decompression apparatus is expelled until the pressure in the apparatus becomes 3×10⁻⁵ Pa, the joining surface 4a of the reflection structure 4 and the joining surface 5a of the heatsink substrate 5 are joined by applying a load of 100 g/cm² in a state in which the semiconductor substrate 11 and the heatsink substrate 5 are heated to 400 °C, thereby forming a joined structure 18.

### <Process for Removing Semiconductor Substrate and Buffer Layer>

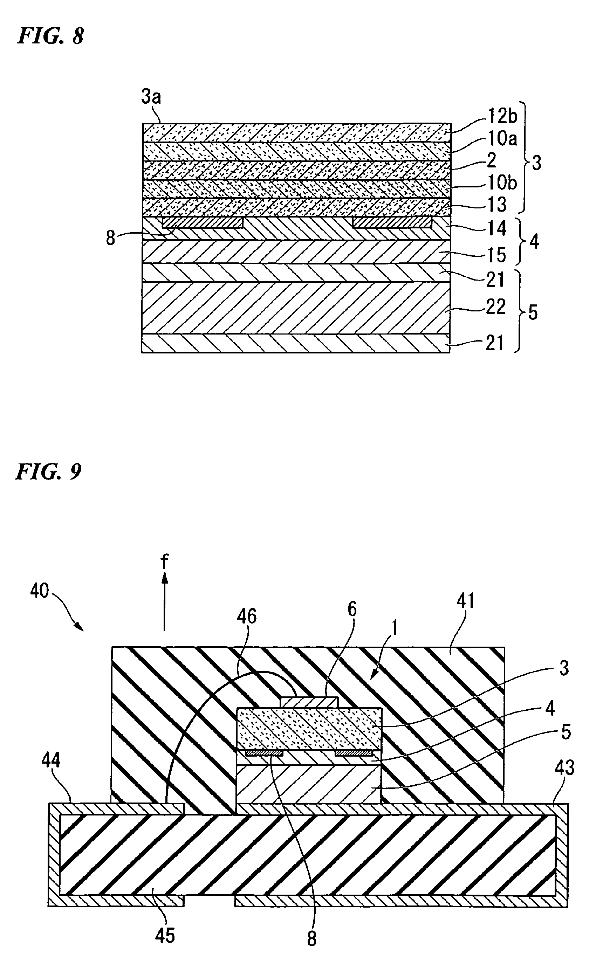

Next, as shown in FIG 8, the semiconductor substrate 11 and the buffer layer 12a are selectively removed from the joined structure 18 using an ammonia-based etchant. Thereby, the light-emitting portion 3 having the light-emitting layer 2 is formed.

### <Process for Forming First Electrode>

Next, a conductive film for electrodes is formed on the surface 3a of the light-emitting portion 3 on the opposite side of the reflection structure 4 using a vacuum deposition method. As the conductive film for electrodes, for example, a metal layer structure composed of AuGe/Ni /Au can be used. For example, after 0.15 µm-thick layer of AuGe (with 12% of Ge mass ratio) is formed, a 0.05 µm-thick layer ofNi is formed, and, furthermore, a 1 µm-thick layer of Au is formed.
Next, using a general photolithography means, the conductive film for the electrode is patterned into a circle shape when viewed from the top, which acts as an n-type ohmic electrode (first electrode) 6, thereby manufacturing the light-emitting diode 1 shown in FIG 1.

Meanwhile, after that, it is preferable to alloy each metal of the n-type ohmic electrode (first electrode) 6 by, for example, performing a thermal treatment at 420 °C for 3 minutes. Thereby, it is possible to reduce the resistance of the n-type ohmic electrode (first electrode) 6.

Meanwhile, after the light-emitting portion 3 at cutting parts, at which the light-emitting diode is divided into a desired size, are removed by etching, the substrate at the cutting parts and a connection layer are cut into a desired size of light-emitting diode chips (LED chips) using a laser with a 0.8-mm pitch. The size of the light-emitting diode refers to, for example, the diagonal length of the substantially rectangular light-emitting portion 3 when viewed from the top, which is set to 1.1 mm. After that, the exposed surfaces of the light-emitting portion 3 are protected with a pressure-sensitive adhesive sheet, and the cut surfaces are washed.

According to the light-emitting diode of the invention, since the heatsink substrate is joined to the light-emitting diode, high light-emitting efficiency can be obtained even in a high electric current zone.

The method for manufacturing the light-emitting diode, which is an embodiment of the invention, includes a process in which the light-emitting portion 3 including the light-emitting layer 2 is formed on the semiconductor substrate 11 via the buffer layer 12a, and then the second electrode 8 is formed on the surface 13a of the light-emitting portion 3 on the opposite side of the semiconductor substrate 11; a process in which the reflection structure 4 is formed on the surface 13a of the light-emitting portion 3 on the opposite side of the semiconductor substrate 11 via the second electrode 8; a process in which the heatsink substrate 5 is joined to the light-emitting portion 3 via the reflection structure 4; a process in which the semiconductor substrate 11 and the buffer layer 12a are removed; and a process in which the first electrode 6 is formed on the surface 3a of the light-emitting portion 3 on the opposite side of the heatsink substrate 5. Thus, the method for manufacturing the light-emitting diode of the invention is possible to manufacture a light-emitting diode that is excellent in terms of thermal radiation properties and is capable of emitting light with high luminance by suppressing cracks in the substrate during joining and by applying a high voltage to the diode.

In the method for manufacturing the light-emitting diode, which is an embodiment of the invention, the heatsink substrate 5 is formed by pressing the first metal layers 21, which has a thermal conductivity of 130 W/m·K or higher and a thermal expansion coefficient substantially similar to the thermal expansion coefficient of the light-emitting portion, and the second metal layer 22 having a thermal conductivity of 230 W/m·K or higher at a high temperature. Thus, the method for manufacturing the light-emitting diode of the invention is possible to manufacture a light-emitting diode that is excellent in terms of thermal radiation properties and is capable of emitting light with high luminance by suppressing cracks in the substrate during joining and by applying a high voltage to the diode.

### <Light-Emitting Diode Lamp>

A light-emitting diode lamp, which is an embodiment of the invention, will be described.
FIG 9 is a schematic cross-sectional view showing an example of a light-emitting diode lamp, which is an embodiment of the invention. As shown in FIG 9, a light-emitting diode lamp 40, which is an embodiment of the invention, includes a package substrate 45, two electrode terminals 43 and 44 formed on the package substrate 45, a light-emitting diode 1 mounted on the electrode terminal 44, and a transparent resin (sealing resin) 41 composed of silicon or the like, which is formed to cover the light-emitting diode 1.
The light-emitting diode 1 has the light-emitting portion 3, the reflection structure 4, the heatsink substrate 5, the first electrode 6, and the second electrode 8, in which the heatsink substrate 5 is disposed to be connected to the electrode terminal 43. In addition, the first electrode 6 and the electrode terminal 44 are wire-bonded.
Voltage applied to the electrode terminals 43 and 44 is applied to the light-emitting portion 3 via the first electrode 6 and the second electrode 8 so that the light-emitting layer included in the light-emitting portion 3 emits light. Emitted light is extracted in the front direction f.

The package substrate 45 is made to have a thermal resistance of 10 °C/W or lower. Thereby, even when 1 W or higher of electric power is applied to the light-emitting layer 2 so as to emit light, it is possible to make the package substrate act as a heatsink and to further increase the thermal radiation properties of the light-emitting diode 1.
Meanwhile, the shape of the package substrate is not limited thereto, and a package substrate having another shape may be used. Since thermal radiation properties can be sufficiently secured even in an LED lamp product using a package substrate having another shape, it is possible to produce a high-power and high luminance light-emitting diode lamp.

The light-emitting diode package 40, which is an embodiment of the invention, is the light-emitting diode lamp 40 having the light-emitting diode 1 and the package substrate 45 mounting the light-emitting diode 1, and the thermal resistance of the package substrate 45 is 10 °C/W or lower. Thus, the light-emitting diode package 40 of the invention may have excellent thermal radiation properties and emit light with high luminance by applying a high voltage to the diode.

Since the light-emitting diode package 40, which is an embodiment of the invention, emits light by adding 1 W or higher of electric power to the light-emitting layer 2 in the light-emitting diode 1, it is possible to be excellent in terms of thermal radiation properties and to emit light with high luminance by applying a high voltage.

### (Second Embodiment)

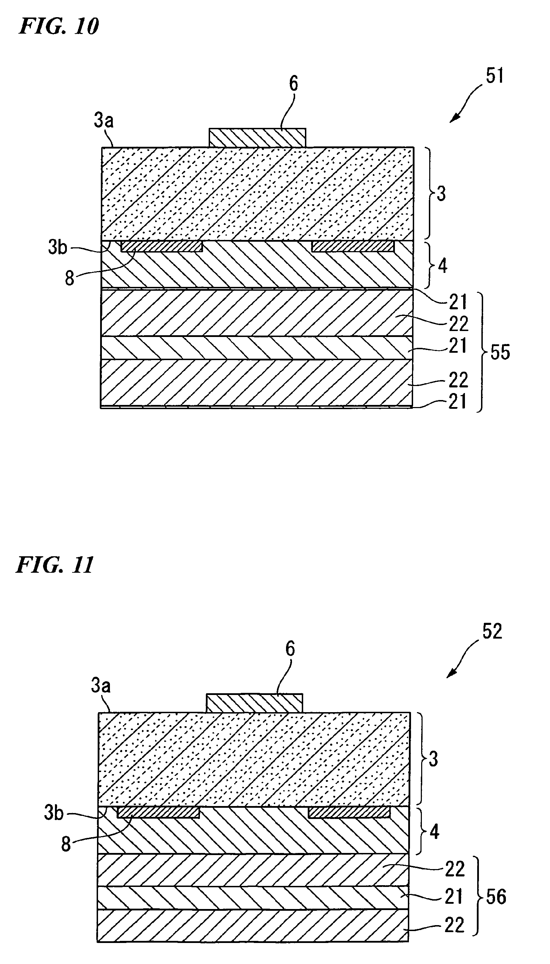

FIG 10 is a view showing a second example of the light-emitting diode, which is an embodiment of the invention.
As shown in FIG 10, a light-emitting diode (LED) 51, which is an embodiment of the invention, is configured in the same manner as the first embodiment except that a heatsink substrate 55 is used instead of the heatsink substrate 5. Meanwhile, members the same as those shown in the first embodiment are given the same reference signs.

The light-emitting diode (LED) 51, which is an embodiment of the invention, has the light-emitting portion 3 including the light-emitting layer (not shown), and the heatsink substrate 55 joined to the light-emitting portion 3 via the reflection structure 4. In addition, the first electrode 6 is provided on the surface 3a of the light-emitting portion 3 on the opposite side of the reflection structure 4, and the second electrode 8 is provided on the surface 3b of the light-emitting portion 3 on the reflection structure 4 side.
A 5-layer structure substrate (with a thickness of 127 µm) of Mo (1 µm)/Cu (50 µm)/Mo (25 µm)/Cu (50 µm)/Mo (1 µm) is used as the heatsink substrate 55, in which Mo is used as the first metal layer 21 and Cu is used as the second metal layer 22.

A method for manufacturing the heatsink substrate 55 will be described. Using the method for manufacturing the heatsink substrate shown in the first embodiment, firstly, a 3-layer structure substrate of Cu (50 µm)/Mo (25 µm)/Cu (50 µm) is manufactured, and then 1 µm-thick Mo is formed on both surfaces of the 3-layer structure substrate using a sputtering method so that the heatsink substrate 55 composed of a 5-layer structure is formed. Meanwhile, the heatsink substrate 55 has a thermal expansion coefficient of 6.6 ppm/K and a thermal conductivity of 230 W/m.K.

### (Third Embodiment)

FIG 11 is a view showing a third example of the light-emitting diode, which is an embodiment of the invention.
As shown in FIG 11, a light-emitting diode (LED) 52, which is an embodiment of the invention, is configured in the same manner as the first embodiment except that a heatsink substrate 56 is used instead of the heatsink substrate 5. Meanwhile, members the same as those shown in the first embodiment are given the same reference signs.

The light-emitting diode (LED) 52, which is an embodiment of the invention, has the light-emitting portion 3 including the light-emitting layer (not shown), and the heatsink substrate 56 joined to the light-emitting portion 3 via the reflection structure 4. In addition, the first electrode 6 is provided on the surface 3a of the light-emitting portion 3 on the opposite side of the reflection structure 4, and the second electrode 8 is provided on the surface 3b of the light-emitting portion 3 on the reflection structure 4 side.
A 3-layer structure substrate (with a thickness of 85 µm) of Cu (30 µm)/Mo (25 µm)/Cu (30 µm) is used as the heatsink substrate 56, in which Mo is used as the first metal layer 21 and Cu is used as the second metal layer 22.

A method for manufacturing the heatsink substrate 56 will be described. Using the method for manufacturing the heatsink substrate shown in the first embodiment, the heatsink substrate 56 composed of a 3-layer structure substrate of Cu (30 µm)/Mo (25 µm)/Cu (30 µm) is manufactured. Meanwhile, the heatsink substrate 56 has a thermal expansion coefficient of 6.1 ppm/K and a thermal conductivity of 250 W/m·K.

### (Fourth Embodiment)

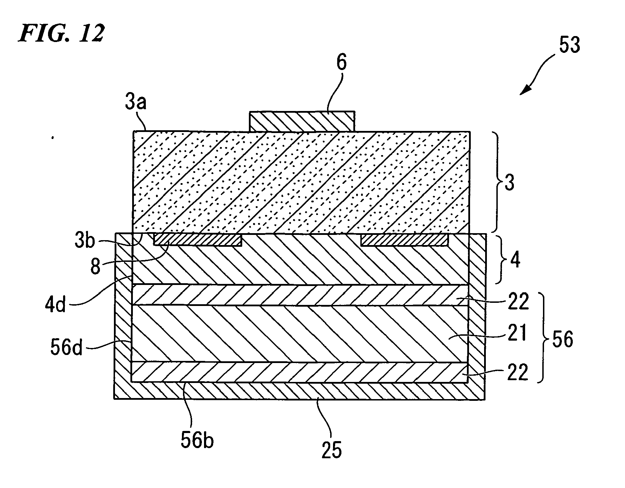

FIG 12 is a view showing a fourth example of the light-emitting diode, which is an embodiment of the invention.
As shown in FIG 12, a light-emitting diode (LED) 53, which is an embodiment of the invention, is configured in the same manner as the third embodiment except that a metal laminate film 25 is formed so as to cover the side surface 4d of the reflection structure 4, and the side surface 56d and the bottom surface 56e of a heatsink substrate 56. Meanwhile, members the same as those shown in the first embodiment are given the same reference signs.

The light-emitting diode (LED) 53, which is an embodiment of the invention, has the light-emitting portion 3 including the light-emitting layer (not shown), and the heatsink substrate 56 joined to the light-emitting portion 3 via the reflection structure 4. In addition, the first electrode 6 is provided on the surface 3a of the light-emitting portion 3 on the opposite side of the reflection structure 4, and the second electrode 8 is provided on the surface 3b of the light-emitting portion 3 on the reflection structure 4 side.
The surface (bottom surface) 56b of the heatsink substrate 56 on the opposite side of the light-emitting portion 3 is made of copper, and the metal laminate film 25 composed of a Ni layer and an Au layer is formed so as to cover the bottom surface 56b and the side surface 56d of the heatsink substrate 56 and the side surface 4d of the reflection structure 4. By forming the metal laminate film 25, it is possible to enhance the thermal radiation properties.
Meanwhile, a plating method or the like can be used as a method for forming the Ni layer and the Au layer.

### [Examples]

Hereinafter, the invention will be described specifically based on examples. However, the invention is not limited to the examples.

### (Example 1)

Firstly, using the method shown in the first embodiment, a heatsink substrate of Example 1 composed of a 3-layer structure of Mo (25 µm)/Cu (70 µm)/Mo (25 µm) was formed. Meanwhile, a Pt (0.1 µm)/Au (0.5 µm) film was formed on the joining surface of the heatsink substrate. The heatsink substrate of Example 1 had a thermal expansion coefficient of 5.7 ppm/K and a thermal conductivity of 220 W/m.K.

Next, using the method shown in the first embodiment, a light-emitting portion and a reflection structure were formed, and also the heatsink substrate was joined thereto so that a light-emitting diode of Example 1 was manufactured.
The contact layer 12b was composed of Si-doped n-type (Al_{0.5}Ga_{0.5})_{0.5}In_{0.5}P, and was made to have a carrier concentration of 2×10¹⁸ cm⁻³ and a thickness of 1.5 µm.
The cladding layer 10a was composed of S i-doped n-type (Al_{0.7}Ga_{0.3})_{0.5}In_{0.5}P, and was made to have a carrier concentration of 8×10¹⁷ cm⁻³ and a thickness of 1 µm. The light-emitting layer 2 was composed of 10 pairs of laminate structures of undoped (Al_{0.2}Ga_{0.8})_{0.5}In_{0.5}P/(Al_{0.7}Ga_{0.3})_{0.5}In_{0.5}P), and was made to have a thickness of 0.8 µm. The cladding layer 10b was composed of Mg-doped p-type (Al_{0.7}Ga_{0.3})_{0.5}In_{0.5}P, and was made to have a carrier concentration of 2×10¹⁷ cm⁻³ and a thickness of 1 µm. In addition, the GaP layer 13 was a Mg-doped p-type GaP layer, and was made to have a carrier concentration of 3×10¹⁸ cm⁻³ and a thickness of 3 µm.
Furthermore, a first electrode was formed to have a laminate structure of AuGe/Ni/Au, and a second electrode was formed to have a laminate structure of AuBe/Au. In addition, a reflection structure was made to have a laminate structure composed of a transparent conductive film, which is composed of ITO, and a Ag alloy/W/Pt/Au/AuGe.
Red light with the main wavelength of 620 nm was emitted by applying 2.4 V to the light-emitting diode of Example 1 and by flowing 500 mA of electric current. High light-emitting efficiency of about 651 m/W was obtained. At this time, due to the effects of the heatsink substrate, the light-emitting diode did not exhibit a decrease in the efficiency induced by an increase in temperature.

### (Example 2)

Firstly, using the method shown in the second embodiment, a heatsink substrate of Example 2 composed of a 5-layer structure (with a thickness of 127 µm) of Mo (1 µm)/Cu (50 µm)/Mo (25 µm)/Cu (50 µm)/Mo (1 µm) was manufactured.
The heatsink substrate of Example 2 had a thermal expansion coefficient of 6.6 ppm/K and a thermal conductivity of 230 W/m·K.

Next, a light-emitting diode of Example 2 was manufactured in the same manner as Example 1 except that the heatsink substrate of Example 2 was used.
Red light with the main wavelength of 620 nm was emitted by applying 2.4 V to the light-emitting diode of Example 2 and by flowing 500 mA of electric current. A high light-emitting efficiency of about 691 m/W was obtained. At this time, due to the effects of the heatsink substrate, the light-emitting diode did not exhibit a decrease in the efficiency induced by an increase in temperature.

### (Example 3)

Firstly, using the method shown in the third embodiment, a heatsink substrate of Example 3 composed of a 3-layer structure (with a thickness of 85 µm) of Cu (30 µm)/Mo (25 µm)/Cu (30 µm) was manufactured.
The heatsink substrate of Example 3 had a thermal expansion coefficient of 6.1 ppm/K and a thermal conductivity of 250 W/m.K.

Next, a light-emitting diode of Example 3 was manufactured in the same manner as Example 1 except that the heatsink substrate of Example 3 was used.
Red light with a main wavelength of 620 nm was emitted by applying 2.4 V to the light-emitting diode of Example 3 and by flowing 500 mA of electric current. A high light-emitting efficiency of about 711 m/W was obtained. At this time, due to the effects of the heatsink substrate, the light-emitting diode did not exhibit a decrease in the efficiency induced by an increase in temperature.

### (Comparative Example 1)

A light-emitting diode of Comparative Example 1 was manufactured in the same manner as Example 1 except that a Si substrate was used as the heatsink substrate. Meanwhile, the Si substrate had a thermal expansion coefficient of 3 ppm/K and a thermal conductivity of 126 W/m.K.
Red light with a main wavelength of 620 nm was emitted by applying 2.4 V to the light-emitting diode of Comparative Example 1 and by flowing 500 mA of electric current. At this time, the light-emitting efficiency of the light-emitting diode of Comparative Example 1 was decreased due to an increase in temperature so as to exhibit about 491 m/W. In addition, 4 of the 10 fed wafers were cracked during the production process. In summary, the cracking ratio (cracking ratio of the wafer) was 40%, which showed a problem in terms of productivity.

### (Comparative Example 2)

A light-emitting diode of Comparative Example 2 was manufactured in the same manner as Example 1 except that a Cu substrate was used as the heatsink substrate. Similarly to Example 1, cracks occurred throughout a wafer when a light-emitting portion and a reflection structure were formed, and then the heatsink substrate was joined thereto. The Cu substrate was considered to have been cracked because the thermal expansion coefficient of the Cu substrate was large.

### (Comparative Examples 3, 4, and 5)

Light-emitting diodes having the heatsink substrates shown in Table 1 were manufactured in the same manner as Examples 1 to 3 and Comparative Examples 1 and 2.
With regard to the light-emitting diodes of Examples 1 to 3 and Comparative Examples 1 to 5, cracks in the wafers and the light-emitting efficiencies (when the electric current value was 500 mA) were investigated and shown in Table 1.
As shown in Table 1, no cracks occurred in the light-emitting diodes of Comparative Examples 3 to 5, but the thermal conductivity of the heatsink substrates of the light-emitting diodes of Comparative Examples 3 to 5 were small, and the light-emitting efficiencies of the light-emitting diodes of Comparative Examples 3 to 5 were decreased due to an increase in temperature.

**[Table 1]**

| | Heatsink substrates | | | | | | | | | | Evaluation | |
|---|---|---|---|---|---|---|---|---|---|---|---|---|
| | No. of metal layers | Thickness of material for each layer (µm) | | | | | Entire thickness (µm) | Ratio of total thickness of first metal layers (%) | Thermal expansion coefficient (ppm/K) | Thermal conductivity (W/mK) | Cracking ratio: cracking ratio of wafer (n = 10 wafers) | Light-emitting efficiency (when electric current value is 500 mA) |
| Example 1 | 3 | Mo (25 µm) | | Cu (70 µm) | | Mo (25 µm) | 120 | 41 | 5.7 | 220 | 0 | 65 |
| Example 2 | 5 | Mo (1 µm) | Cu (50 µm) | Mo (25 µm) | Cu (50 µm) | Mo (1 µm) | 127 | 21 | 6.6 | 230 | 0 | 69 |
| Example 3 | 3 | Cu (30 µm) | | Mo (25 µm) | | Cu (30 µm) | 85 | 29 | 6.1 | 250 | 0 | 71 |
| Comparative Example 1 | 1 | Si | | | | | 100 | - | 3 | 126 | 40% | 49 |
| Comparative Example 2 | 1 | Cu | | | | | 150 | - | 17 | 394 | 100% | - |
| Comparative Example 3 | 1 | Gap | | | | | 150 | - | 5.3 | 110 | 0 | 43 |
| Comparative Example 4 | 1 | Mo | | | | | 100 | - | 5.1 | 138 | 0 | 52 |
| Comparative Example 5 | 1 | W | | | | | 100 | - | 4.3 | 174 | 0 | 58 |

### [Industrial Applicability]

The light-emitting diode of the invention can be improved in terms of thermal radiation properties and thus can be used for a variety of display lamps, lighting devices, or the like that emit light with unprecedentedly high luminance, and has applicability in industries manufacturing and using the display lamps, lighting devices, or the like.

### [Reference Signs List]

1 LIGHT-EMITTING DIODE (LIGHT-EMITTING DIODE CHIP)
2 IGHT-EMITTING LAYER
3 LIGHT-EMITTING PORTION
3a SURFACE ON THE OPPOSITE SIDE OF REFLECTION STRUCTURE
3b SURFACE ON THE REFLECTION STRUCTURE SIDE
4 REFLECTION STRUCTURE
5 HEATSINK SUBSTRATE
5a JOINING SURFACE
5b SURFACE ON THE OPPOSITE SIDE OF JOINING SURFACE
6 FIRST ELECTRODE
8 SECOND ELECTRODE
8b SURFACE ON THE OPPOSITE SIDE OF LIGHT-EMITTING PORTION
11 SEMICONDUCTOR SUBSTRATE (SUBSTRATE FOR EPITAXIAL GROWTH)
11a CRYSTAL-GROWN SURFACE
10a and 10b CLADDING LAYER
12a BUFFER LAYER
12b CONTACT LAYER
13 GaP LAYER
13a SURFACE ON THE OPPOSITE SIDE OF SEMICONDUCTOR SUBSTRATE
14 TRANSPARENT CONDUCTIVE FILM
15 METALLIC JOINING FILM
15b SURFACE ON THE OPPOSITE SIDE OF LIGHT-EMITTING PORTION
17 EPITAXIAL LAMINATE
21 FIRST METAL LAYER
22 SECOND METAL LAYER
25 METAL LAMINATE FILM
40 LIGHT-EMITTING DIODE LAMP
41 RESIN
43 and 44 ELECTRODE TERMINAL
45 SUBSTRATE
46 WIRE
51, 52, and 53 LIGHT-EMITTING DIODE (LIGHT-EMITTING DIODE CHIP)
55 and 56 HEATSINK SUBSTRATE

## Claims

1. A light-emitting diode comprising a heatsink substrate joined to a light-emitting portion including a light-emitting layer,
wherein the heatsink substrate is formed by alternately laminating a first metal layer and a second metal layer;
the first metal layer has a thermal conductivity of 130 W/m·K or higher and is made of a material having a thermal expansion coefficient substantially similar to the thermal expansion coefficient of a material for the light-emitting portion; and
the second metal layer is made of a material having a thermal conductivity of 230 W/m.K or higher.

2. The light-emitting diode according to Claim 1,
wherein a material for the first metal layer has a thermal expansion coefficient within ±1.5 ppm/K of the thermal expansion coefficient of the light-emitting portion.

3. The light-emitting diode according to Claim 1 or 2,
wherein the first metal layer is made of molybdenum, tungsten, or an alloy thereof.

4. The light-emitting diode according to any one of Claims 1 to 3,
wherein the second metal layer is made of aluminum, copper, silver, gold, or an alloy thereof.

5. The light-emitting diode according to any one of Claims 1 to 4,
wherein the first metal layer is made of molybdenum; the second metal layer is made of copper; and the total number of the first metal layers and the second metal layers is from 3 layers to 9 layers.

6. The light-emitting diode according to any one of Claims 1 to 5,
wherein the first metal layer is made of molybdenum, and the total thickness of the first metal layers is from 15% to 45% of the thickness of the heatsink substrate.

7. The light-emitting diode according to any one of Claims 1 to 6, comprising a reflection structure between the light-emitting portion and the heatsink substrate.

8. The light-emitting diode according to any one of Claims 1 to 7,
wherein the light-emitting layer includes an AlGaInP layer or an AlGaAs layer.

9. The light-emitting diode according to any one of Claims 1 to 8,
wherein the light-emitting layer has a substantially rectangular shape with a diagonal length of 1 mm or larger when viewed from the top, and light is emitted by applying 1 W or more of electric power to the light-emitting layer.

10. The light-emitting diode according to any one of Claims 1 to 9,
wherein a surface of the heatsink substrate on the opposite side of the light-emitting portion is made of copper, and a metal laminate film is formed so as to cover the surface on the opposite side of the light-emitting portion and a side surface of the heatsink substrate.

11. A light-emitting diode lamp, comprising: the light-emitting diode according to any one of Claims 1 to 10 and a package substrate mounting the light-emitting diode,
wherein the thermal resistance of the package substrate is 10 °C/W or lower.

12. The light-emitting diode lamp according to Claim 11,
wherein light is emitted by applying 1 W or more of electric power to a light-emitting layer of the light-emitting diode.

13. A method for manufacturing a light-emitting diode, comprising:
a process in which a light-emitting portion including a light-emitting layer is formed on a semiconductor substrate via a buffer layer, and then a second electrode is formed on a surface of the light-emitting portion on the opposite side of the semiconductor substrate;
a process in which a reflection structure is formed on a surface of the light-emitting portion on the opposite side of the semiconductor substrate via the second electrode;
a process in which a heatsink substrate is joined to the light-emitting portion via the reflection structure;
a process in which the semiconductor substrate and the buffer layer are removed; and
a process in which a first electrode is formed on a surface of the light-emitting portion on the opposite side of the heatsink substrate.

14. The method for manufacturing a light-emitting diode according to Claim 13,
wherein the heatsink substrate is formed by pressing first metal layers, which has a thermal conductivity of 130 W/m·K or higher and a thermal expansion coefficient substantially similar to the thermal expansion coefficient of the light-emitting portion, and a second metal layer having a thermal conductivity of 230 W/m·K or higher at a high temperature.
